# EUROPÄISCHE PATENTSCHRIFT

(11) **EP 0 632 901 B1**
(45) Veröffentlichungstag und Bekanntmachung des Hinweises auf die Patenterteilung: **11.09.1996**
(21) Anmeldenummer: 93906504.1
(22) Anmeldetag: 11.03.1993
(51) Int. Cl.: G01R 31/28, G06F 11/26, G01R 31/318

(54) **VERFAHREN ZUM TESTEN VON ABSCHLUSSWIDERSTÄNDEN IN ECL-NETZEN**
PROCESS FOR TESTING TERMINAL RESISTANCES IN ECL NETWORKS
PROCEDE POUR TESTER LES RESISTANCES TERMINALES DANS LES RESEAUX A CIRCUIT DE LOGIQUE COUPLE A L'EMETTEUR (ECL)

(30) Priorität: 27.03.1992 DE 4210108
(43) Veröffentlichungstag der Anmeldung: 11.01.1995
(73) Patentinhaber: Siemens Nixdorf Informationssysteme Aktiengesellschaft, D-33102 Paderborn (DE)
(72) Erfinder: TANNHÄUSER, Rolf, D-82152 Krailling (DE)
(74) Vertreter: Fuchs, Franz-Josef, Dr.-Ing.
(86) Internationale Anmeldenummer: EP9300565
(87) Internationale Veröffentlichungsnummer: WO9320456

(56) Entgegenhaltungen:
- PATENT ABSTRACTS OF JAPAN vol. 13, no. 279 (P-891) 27. Juni 1989 & JP-A-10 68 667
- PATENT ABSTRACTS OF JAPAN vol. 11, no. 382 (E-564) 12. Dezember 1987 & JP-A-62 146 014
- PROCEEDINGS OF THE 1990 BIPOLAR CIRCUITS AND TECHNOLOGY MEETING 17. September 1990, Minneapolis, USA, SS. 128-131; SHOOKHTIM et al.: 'Novel Boundary Scan Circuit and Methodology for ECL/BiCMOS VLSI'
- ELECTRONICS LETTERS Bd. 29, Nr. 3, 4. Februar 1993, Enage, GB, SS. 294-296; MILES, J.R.: 'Testing terminated printed circuit interconnections using boundary scan'

## Beschreibung

Die Erfindung betrifft ein Verfahren zum Testen von Abschlußwiderständen von Signalleitungen zwischen Sender und Empfänger in mit ECL-Logikbausteinen aufgebauten Netzen unter Ausnutzung der für Prüfzwecke in den Bausteinen integrierten Boundary-Scan-Zellen.

ECL-Netze werden auf Baugruppen am Ende der Signalübertragungsstrecke mit Abschlußwiderständen, z.B. 50 Ohm gegen - 2 Volt abgeschlossen. Fehlen diese Abschlußwiderstände auf Grund von Fehlern im Fertigungsprozeß, so führt dies zu Signalverformungen auf der Übertragungsstrecke und somit zur Verschlechterung des dynamischen Verhaltens der Schaltung. Diese Fehlerart (dynamische Fehler) ist prüftechnisch schwierig und aufwendig zu erkennen und zu diagnostizieren, besonders bei Einbautechniken hoher Packungsdichte, da hier eine Prüfung mit Incircuit-Tester und Nadelbettadapter auf Grund der Signaldichte und Pindichte nicht realisiert werden kann.

Schaltungskomplexe werden zunehmend mit dem sogenannten Boundary-Scan-Bus (IEEE Std. 1149.1-1990) ausgestattet. Beim Boundary-Scan-Prüfverfahren lassen sich alle Eingangs- und Ausgangssignale der Bausteine auf der Baugruppe zu einem Scan-Path zusammenschalten. Dieser Scan-Path ist auf vier bzw. fünf Steckerpins der Baugruppe geführt. Somit können alle Bausteineingangs- und -ausgangssignale innerhalb der Baugruppe über diese Steckerpins stimuliert bzw. beobachtet werden. Dies erlaubt den Test der einzelnen Bausteine im sog. Internal-Testmode und den Test aller Verbindungen im sog. External-Testmode. Die Abschlußwiderstände in ECL-Netzen werden durch diese Standard-Testarten aber nicht erfaßt.

Aufgabe der vorliegenden Erfindung ist es, ein einfaches Testverfahren für Abschlußwiderstände in ECL-Netzen anzgeben.

Zur Lösung dieser Aufgabe wird gemäß der Erfindung dabei so verfahren, daß alle Signalleitungen der zu prüfenden Netze auf logisch Null gelegt und daß unter Ausnutzung der für Prüfzwekke in den Bausteinen integrierten Boundary-Scan-Zellen die Abschlußspannungen an den Abschlußwiderständen so hoch angehoben werden, daß in den Boundary-Scan-Empfangszellen bei vorhandenen bzw. intakten Abschlußwiderständen eine logische 1 erscheint, und daß die Spannungen der Abschlußwiderstände der Boundary-Scan-Leitungen unabhängig von den Abschlußspannungen in den zu testenden Netzen sind.

Die Unabhängigkeit der Abschlußspannung der Abschlußwiderstände für die Boundary-Scan-Leitungen kann entweder dadurch erreicht werden, daß sie über einen Spannungsteiler erzeugt wird, der 80 Ohm gegen 0 Volt und 130 Ohm gegen -5,2 Volt aufweist oder daß die Verbindungsleitungen von einem Senderausgang zu einem Empfängereingang von der Testdatenausgangsleitung zu den Testdateneingangsleitungen sourceterminated betrieben wird, oder daß die Abschlußwiderstände der Boundary-Scan-Leitungen mit einer eigenen Abschlußspannung betrieben werden.

Durch diese Maßnahmen werden unter Mitverwendung der in den einzelnen Bausteinen vorgesehenen Boundary-Scan-Zellen aufwendige Prüfeinrichtungen vermieden.

Anhand der Ausführungsbeispiele nach den Figuren 1 und 2 sowie der Figur 3 wird die Erfindung näher erläutert.
Es zeigen
Figur 1 ein Blockschaltbild eines ECL-Netzwerkes mit Boundray-Scan-Zellen in den einzelnen Bausteinen,
Figur 2 einen Ausschnitt aus Figur 1,
Figur 3 eine Skizze der Prüfschaltung für den externen Testmod des Boundary-Scan-Prüfverfahrens.

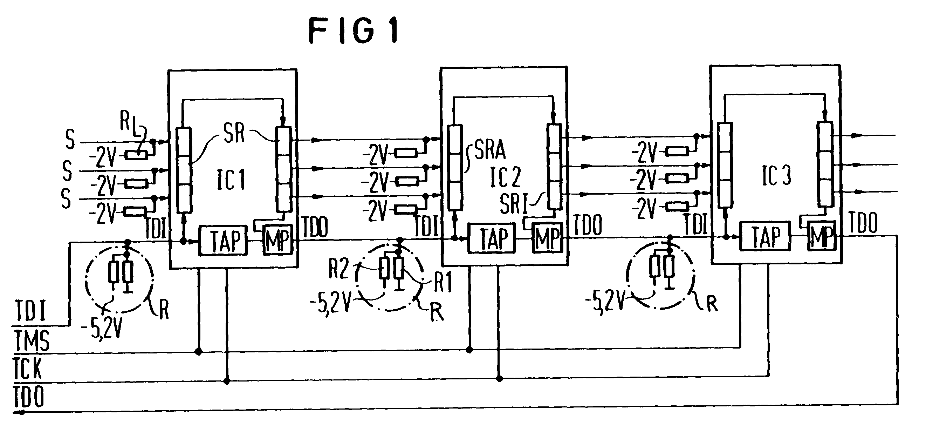

In Figur 1 ist ein Teil der ECL-Netze mit drei Bausteinen IC1, IC2, IC3 dargestellt. Die Signalleitungen S sind jeweils gegen - 2 Volt mit den Abschlußwiderständen R_{L} abgeschlossen. Die für die Boundary-Scan-Prüfmethode notwendigen Boundary-Scan-Zellen SR sind schematisch in den einzelnen Bausteinen IC1.. IC3 angedeutet.

Die Boundary-Scan-Zellen sind in jeden einzelnen Baustein integriert und bestehen hauptsächlich aus einem Schieberegister, in dem alle Ein- und Ausgänge eines Bauelements IC1..IC3 eingebunden sind. Die Boundary-Scan-Zellen sind zwischen den Pads der Bauelemente IC1..IC3 und der internen Logik BLA, BLB der Bauelemente IC1..IC3 eingefügt und können während des Betriebs der Schaltung für Testzwecke benutzt werden. Uber einen Test-Access-Port wird dieses Register auf einer mehrere Bauelemente tragenden Baugruppe mit dem jeweils anderen Bauelement verbunden. Damit können ähnlich dem Scan-Path-Prüfverfahren bei Bauelementen auf der Baugruppe seriell Testdaten ein- und ausgeschoben werden. Über diese flexible Schnittstelle des Test-Access-Port TAP erfolgt die Kommunikation mit allen bausteininternen Testhilfen. Sie besteht aus vier Pins, die für das Boundary-Scan-Prüfverfahren anfallen. Diese vier Pins sind in Figur 1 mit TDI, TMS, TCK und TDO bezeichnet. TDI bezeichnet den Test Data Input. Uber diesen Pin werden alle Testdaten und Instruktionen seriell eingeschoben. Über den Pin TDO (Test Data Output) werden alle Testantworten seriell ausgeschoben. Durch ein serielles Protokoll an dem Test Mode Select-Pin TMS werden die Testaktivitäten auf dem Bauelement gesteuert, während über den Test Clock-Pin TCK ein vom Systemtakt unabhängiger Testtakt angelegt wird. Dies erlaubt es auch, während des Betriebs des Bauelementes auf Testeinrichtungen zugreifen zu können. Die Boundary-Scan-Leitungen können sowohl sourceterminated (d.h. Reihenwiderstand im Ausgang des Senderbausteins bei Punkt zu Punktverbindung, (ein Sender versorgt nur einen Empfänger) als auch endterminated (d.h. Abschlußwiderstände am Ende der Signalleitungen) betrieben werden.

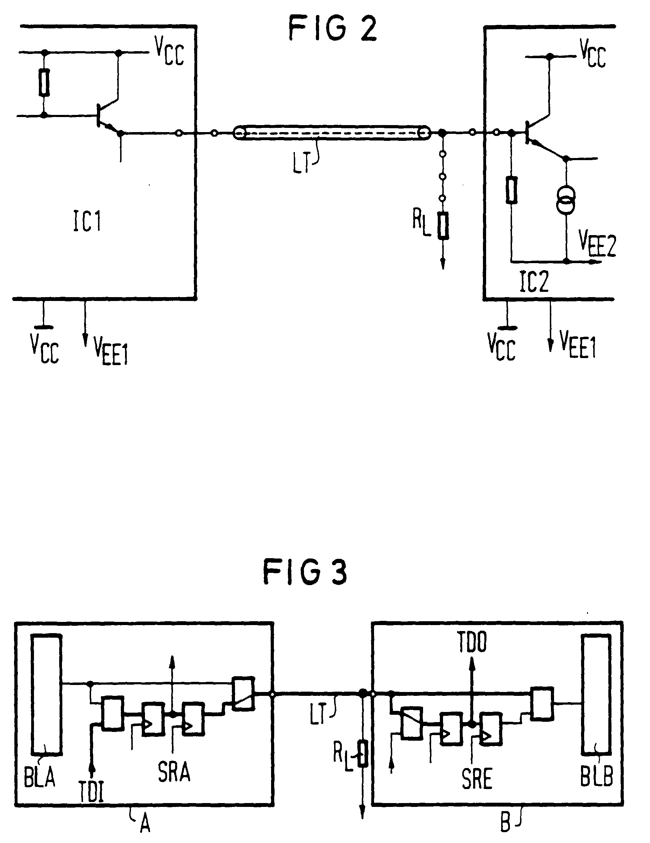

Bei der Anordnung nach der Figur 2 ist lediglich schematisch der Ausgang des Bauelements IC1 ("Sender") und der Eingang des Bauelements IC2 ("Empfänger") dargestellt, die beide über die Leitung LT miteinander verbunden sind. Am Ende der Leitung LT liegt der Abschlußwiderstand RL an der Spannung VEE2, die - 2 Volt beträgt. Die Spannung VCC beträgt 0 Volt, die Spannung VEE1 - 5,2 Volt.

Die Prüfschaltung für den externen Testmodus, also für jenen Modus, bei dem die zwischen den Ausgangszellen des Bauelements A und den Eingangszellen des Bauelements B liegende Verbindungsleitung geprüft werden soll, ist in Figur 3 dargestellt. Bei diesem Modus werden über die Boundary-Scan-Register-Ausgangszellen SRA Testmuster in die Ausgangszellen des Bauelements A eingeschoben und Muster an die Ausgänge des Bauelements A gelegt. In den Eingangszellen des Bauelements B werden dann die Testworte gespeichert und über die Boundary-Scan-Register-Eingangszellen SRE ausgeschoben. Mit dieser Testmethode kann zwar, wie eingangs bereits erläutert, die zwischen zwei Zellen liegende Logik bzw. Verbindungsleitung auf Fehler überprüft werden, nicht jedoch der Abschlußwiderstand R_{L} der jeweiligen Verbindungsleitung. Man kann jedoch erfindungsgemäß die Boundary-Scan-Zellen zur Prüfung auch dieser Abschlußwiderstände R_{L} ausnützen, wenn man alle Signalleitungen auf logisch Null legt, die Abschlußspannung der Abschlußwiderstände R_{L}, im vorliegenden Beispiel, von - 2 Volt auf - 0,8 bzw. 0 Volt anhebt und anschließend den vorstehend beschriebenen externen Testmode durchführt, d.h. die Eingangszellen des jeweils nächstfolgenden Bauelements bewertet. Als Ergebnis zeigt sich nämlich, daß alle Netze mit Abschlußwiderstand dann an den Eingangs zellen eine logische Eins aufweisen. Als Designmaßnahme auf der Baugruppe ist es in diesem Fall lediglich erforderlich, daß der Boundary-Scan-Bus entweder ohne Abschlußwiderstände betrieben wird (z.B. sourceterminated) oder die Abschlußwiderstände des Busses als Spannungsteiler, z.B. 80 Ohm gegen 0 Volt und 130 0hm gegen - 5,2 Volt ausgeführt werden.

## Patentansprüche

1. Verfahren zum Testen von Abschlußwiderständen von Signalleitungen zwichen Sender und Empfänger in mit ECL-Logikbausteinen aufgebauten Netzen unter Ausnutzung der für Prüfzwecke in den Bausteinen integrierten Boundary-Scan-Zellen, **dadurch gekennzeichnet**, daß alle Signalleitungen (S) der zu prüfenden Netze auf logisch Null gelegt und die Abschlußspannungen an den Abschlußwiderständen (R_{L}) so hoch angehoben werden, daß in den Boundary-Scan-Eingangszellen (SRE) bei Anwendung des externen Testmodus des Boundary-Scan-Prüfverfahrens bei vorhandenen bzw. intakten Abschlußwiderständen (R_{L}) eine logische 1 erscheint und daß die Spannungen der Abschlußwiderstände (R) der Boundary-Scan-Leitungen unabhängig von den Abschlußspannungen (VEE2) der zu testenden Netze sind.

2. Verfahren nach Anspruch 1, **dadurch gekennzeichnet**, daß die Abschlußspannung der Boundary-Scan-Leitungen über einen Spannungsteiler (R₁,R₂) erzeugt werden, der 80 Ohm gegen 0 Volt und 130 Ohm gegen 5,2 Volt aufweist.

3. Verfahren nach Anspruch 1, **dadurch gekennzeichnet**, daß die Abschlußwiderstände (R) der Boundary-Scan-Leitung mit einer eigenen Abschlußspannung betrieben werden.

4. Verfahren zum Testen von Abschlußwiderständen von Signalleitungen zwichen Sender und Empfänger in mit ECL-Logikbausteinen aufgebauten Netzen unter Ausnutzung der für Prüfzwecke in den Bausteinen integrierten Boundary-Scan-Zellen, **dadurch gekennzeichnet**, daß alle Signalleitungen (S) der zu prüfenden Netze auf logisch Null gelegt und die Abschlußspannungen an den Abschlußwiderständen (R_{L}) so hoch angehoben werden, daß in den Boundary-Scan-Eingangszellen (SRE) bei Anwendung des externen Testmodus des Boundary-Scan-Prüfverfahrens bei vorhandenen bzw. intakten Abschlußwiderständen (R_{L}) eine logische 1 erscheint und daß die Verbindungsleitungen von einem Senderausgang zu einem Empfängereingang von der Testdatenausgangsleitung (TDO) zu den Testdateneingangsleitungen (TDI) source terminated betrieben werden.

## Claims

1. Process for testing terminal resistances of signalling lines between emitters and receivers in networks constructed with ECL logic components utilizing the boundary scan cells integrated in the components for testing purposes, characterized in that all the signalling lines (S) of the networks to be tested are set to logical zero and the terminal voltages at the terminal resistances (R_{L}) are increased until a logical 1 appears in the boundary scan input cells (SRE) when the terminal resistances (R_{L}) are present and intact when the external test mode of the boundary scan test procedure is applied, and in that the voltages of the terminal resistances (R) of the boundary scan lines are independent of the terminal voltages (VEE2) of the networks to be tested.

2. Process according to Claim 1, characterized in that the terminal voltage of the boundary scan lines is generated by means of a voltage divider (R₁, R₂) which has 80 ohms against 0 volts and 130 ohms against 5.2 volts.

3. Process according to Claim 1, characterized in that the terminal resistances (R) of the boundary scan line are operated with a separate terminal voltage.

4. Process for testing terminal resistances of signalling lines between emitters and receivers in networks constructed with ECL logic components utilizing the boundary scan cells integrated in the components for testing purposes, characterized in that all the signalling lines (S) of the networks to be tested are set to logical zero and the terminal voltages at the terminal resistances (R_{L}) are increased until a logical 1 appears in the boundary scan input cells (SRE) when the terminal resistances (R_{L}) are present and intact when the external test mode of the boundary scan test procedure is applied, and in that the connecting lines from an emitter output to a receiver input from the test data output line (TDO) to the test data input lines (TDI) are operated in a source-terminated manner.

## Revendications

1. Procédé d'essai de résistances de terminaison de conducteurs de transmission de signaux entre un émetteur et un récepteur dans des réseaux constitués de composants logiques ECL, en utilisant les cellules Boundary-Scan intégrées, à des fins de vérification, aux composants, caractérisé en ce que l'on met tous les conducteurs (S) de transmission de signaux des réseaux à vérifier au zéro logique et on élève les tensions de terminaison aux bornes des résistances (R_{L}) de terminaison, de sorte qu'il apparaisse dans les cellules d'entrée (SRE) Boundary-Scan, lorsqu'on utilise le mode d'essai extérieur du procédé de vérification Boundary-Scan et lorsque les résistances (R_{L}) de terminaison sont présentes ou intactes, un 1 logique et que les tensions aux bornes des résistances (R) de terminaison des conducteurs Boundary-Scan soient indépendantes des tensions (VEE2) de terminaison des réseaux à essayer.

2. Procédé suivant la revendication 1, caractérisé en ce que on produit la tension de terminaison des conducteurs Boundary-Scan par l'intermédiaire d'un diviseur (R₁, R₂) de tension, qui a 80 ohms à 0 volt et 130 ohms à 5,2 volts.

3. Procédé suivant la revendication 1, caractérisé en ce que l'on fait fonctionner les résistances (R) de terminaison du conducteur Boundary-Scan à une tension de terminaison qui lui est propre.

4. Procédé d'essai de résistances de terminaison de conducteurs de transmission de signaux entre un émetteur et un récepteur dans des réseaux constitués de composants logiques ECL, en utilisant les cellules Boundary-Scan intégrées, à des fins de vérification, aux composants, caractérisé en ce que l'on met tous les conducteurs (S) de transmission de signaux des réseaux à vérifier au zéro logique et on élève les tensions de terminaison aux bornes des résistances (R_{L}) de terminaison, de sorte qu'il apparaisse dans les cellules (SRE) d'entrée Boundary-Scan, lorsqu'on utilise le mode d'essai extérieur du procédé de vérification Boundary-Scan et lorsque les résistances (R_{L}) de terminaison sont présentes ou intactes, un 1 logique et que l'on fasse fonctionner les conducteurs de liaison d'une sortie de l'émetteur avec une entrée du récepteur en terminaison de source, du conducteur (TDO) de sortie de données d'essai aux conducteurs (TDI) d'entrée de données d'essai.
